Europäisches Patentamt

European Patent Office

Office européen des brevets

(19)

(11) Numéro de publication : **0 317 442 B1**

# FASCICULE DE BREVET EUROPEEN

(12)

(45) Date de publication du fascicule du brevet :
**15.01.92 Bulletin 92/03**

(51) Int. Cl.⁵ : **G11C 17/00,** G11C 16/00

(21) Numéro de dépôt : **88402906.7**

(22) Date de dépôt : **18.11.88**

(54) **Plan mémoire et procédé et prototye de définition d'un circuit intégré électronique comportant un tel plan mémoire.**

(30) Priorité : **20.11.87 FR 8716063**

(43) Date de publication de la demande :
**24.05.89 Bulletin 89/21**

(45) Mention de la délivrance du brevet :
**15.01.92 Bulletin 92/03**

(84) Etats contractants désignés :
**DE ES GB IT NL**

(56) Documents cités :
**EP-A- 0 224 206**
**EP-A- 0 227 965**
**EP-A- 0 239 283**
**PATENT ABSTRACTS OF JAPAN, vol. 6, no. 51
(P-108)[929], 6 avril 1982, page 150 P 108; &
JP-A-56 165 984 (NIPPON DENKI K.K.) 19-
12-1981**

(73) Titulaire : **SGS-THOMSON
MICROELECTRONICS S.A.
7, Avenue Galliéni
F-94250 Gentilly (FR)**

(72) Inventeur : **Sourgen, Laurent
CABINET BALLOT-SCHMIDT 84, Avenue
Kléber
F-75116 Paris (FR)**
Inventeur : **Lisimaque, Gilles
CABINET BALLOT-SCHMIDT 84, Avenue
Kléber
F-75116 Paris (FR)**
Inventeur : **Devin, Jean
CABINET BALLOT-SCHMIDT 84, Avenue
Kléber
F-75116 Paris (FR)**

(74) Mandataire : **Ballot, Paul Denis Jacques et al
Cabinet Ballot-Schmit 7, rue le Sueur
F-75116 Paris (FR)**

EP 0 317 442 B1

## Description

La présente invention a pour objet un plan mémoire ainsi qu'un procédé de définition d'un circuit intégré électronique comportant un tel plan mémoire. Elle trouve son application dans le domaine des mémoires dont des cellules mémoires comportent comme organe de mémorisation un transistor à grille flottante programmable électriquement (EPROM ou EEPROM). Elle concerne des plans mémoires qui sont susceptibles de contenir à la fois des cellules mémoires vives et des cellules mémoires mortes. Des cellules mémoires vives sont des cellules mémoires qui peuvent être programmées par un microprocesseur qui gère le plan mémoire en fonction des besoins manifestés par un utilisateur. Les cellules mémoire mortes ne sont pas destinées à être programmées par ce microprocesseur. Elles comportent des informations relatives à des instructions de fonctionnement du circuit intégré, du microprocesseur, ou du plan mémoire lui-même. Elles peuvent aussi contenir des codes secrets, des clefs d'accès, ou des algorithmes de protection.

Un des principaux problèmes présenté par les cellules mémoires mortes se situe dans le caractère décriptable du contenu d'information qu'elles renferment. En effet, à fortiori quand les cellules mémoires mortes sont réalisées dans des plans mémoires juxtaposés, et de technologie différente de celle du plan mémoire des cellules mémoires vives, la mise en évidence de leur contenu d'information peut être réalisée au moyen d'un microscope. Par exemple, dans une technologie simple le contenu des informations programmées peut en effet être révélé par la présence ou l'absence d'une connexion, par la présence ou l'absence d'un fusible, ou par la présence ou l'absence d'une jonction électronique, d'une diode. Dans le cas des fusibles les cellules mémoires mortes peuvent être définies, par programmation, directement par l'utilisateur. Dans les autres cas, la définition du plan d'une mémoire morte doit être déterminée suffisamment en amont du processus de fabrication du circuit intégré électronique qui la contient. Dans tous les cas cependant, la présence ou l'absence de ces fonctions électroniques rendent alors le déchiffrage du contenu des cellules mémoires mortes de la mémoire morte relativement aisé.

Un fraudeur qui se livrerait sur un tel circuit intégré à une démarche visant à dévoiler le contenu de ces mémoires mortes verrait en outre son travail facilité par le fait que la technologie de fabrication des cellules mémoires mortes est aussi fort différente de la technologie de fabrication des cellules mémoires du plan des mémoires vives. Pour des raisons de fabrication, et comme si on voulait rendre cette fraude plus simple, les plans mémoires des cellules mémoires vives et les plans mémoires des cellules mémoires mortes sont géographiquement bien différenciés dans le plan mémoire général du circuit. De telle façon que le fraudeur n'a aucun mal à trouver l'emplacement de ces cellules mémoires mortes. Après une dépassivation du circuit intégré électronique, après enlèvement des couches de protection, il peut alors avoir accès facilement aux informations contenues.

Un autre problème présenté par les plans des cellules mémoires mortes se situe dans le caractère modulable de leur taille. En effet, si pour certaines applications un plan mémoire des cellules mémoires mortes de taille relativement restreinte se justifie, pour d'autres applications, plus exigeantes, un plan mémoire plus important peut être nécessaire. Les circuits électroniques ainsi fabriqués ne peuvent pas avoir alors de caractère universel. Il doivent être répartis par catégories, différenciées les unes des autres par exemple par la taille des plans de mémoire morte qu'ils sont susceptibles de posséder. Cette diversité de fabrication n'est pas propice à une rentabilité élevée d'une part, ni à une grande fiabilité de réalisation d'autre part.

Un autre problème a été rencontré lorsqu'il s'agit de concevoir des circuits intégrés électroniques comportant des plans mémoires. En effet la phase de mise au point du prototype doit tenir compte du fonctionnement intime du circuit intégré global. Les choix concernant la catégorie de circuits intégrés électroniques, avec un nombre de cellules mémoires mortes donné, sont alors déterminants dans le résultat final. L'inconvénient que comportent ces choix est qu'ils doivent être faits bien en amont de la réalisation des circuits, même de celle du prototype, ce qui en cas d'erreur peut conduire à une grande perte de temps dans la réalisation du circuit intégré électronique en question. En définitive ces choix doivent orienter dès l'origine la fabrication des circuits électroniques désirés. Ils conditionnent la mise au point de la fonctionnalité et des possilités de fabrication du circuit en question. Cette contrainte va en sens inverse de l'évolution historique dans ce domaine où, comme dans la technique dite des prédiffusés, dans laquelle on essaye de réaliser le plus possible de phases de fabrication du circuit intégré électronique avant de le définir pour une application déterminée. En résumé le but à atteindre consiste, pour un plan mémoire de taille mémoire donnée, à pouvoir faire le plus tard possible le distinguo entre ce qui doit être la part réservée aux cellules mémoires vives et ce qui doit être la part réservée aux cellules mémoires mortes.

L'invention à pour objet de remédier à ces inconvénients en proposant un nouveau plan mémoire où la technologie de fabrication des cellules mémoires mortes est en partie la même que la technologie de fabrication des cellules mémoires vives. L'invention part du principe que dans une cellule mémoire vive non volatile, possédant comme organe de mémorisation un transistor à grille flottante, il est connu de doper, avec des impuretés de même type que le substrat (enrichissement), le canal de conduction de ce transistor à grille flottante pour favoriser les conditions de programmation de cette cellule. En effet il est connu que si le canal de conduction est dopé, il n'est dopé qu'en surface. La turbulence qui agite les électrons, au moment de la mise en saturation de ce transistor pour le programmer, a alors un effet d'injection de ces électrons dans la grille flottante d'autant plus efficace. Tout simplement, si le canal n'est pas dopé, la turbulence de conduction se produit dans toute l'épaisseur du canal, et les électrons injectés depuis le fond du canal perdent en partie leur énergie pour remonter à la surface de ce canal, en direction de l'oxyde de grille qui les sépare de la grille flottante. Comme leur énergie a été réduite ils sont alors insuffisamment mobiles pour franchir cette barrière d'oxyde de grille. Le rendement d'injection est alors plus faible.

Cependant le fait d'injecter des impuretés dans un canal de conduction, en vue de favoriser l'opération de programmation, a pour effet de déplacer vers les valeurs élevées la tension de seuil de conduction de ces transistors à grille flottante. Par exemple la tension drain-source à laquelle un transistor à grille flottante non programmé se met à conduire est de l'ordre de 1 volt quand son canal de conduction n'est pas dopé, mais devient de l'ordre de 1,5 volts quand son canal de conduction est dopé. Ceci a pour conséquence qu'au moment de la lecture du contenu de l'information stockée dans une telle cellule mémoire, et en fonction d'une tension drain-source imposée à ce transistor, le courant qu'il est susceptible de débiter sera plus faible quand ce canal de conduction est dopé que quand il ne l'est pas.

Dans l'invention on met à profit ce phénomène, par exemple en l'exagérant, pour différencier des cellules mémoires mortes non programmées de cellules mémoires mortes programmées. On fait alors la distinction entre le courant qu'est susceptible de débiter une cellule mémoire morte selon que son canal de conduction a été plus ou moins dopé selon l'état de programmation qu'on a voulu lui imposer.

Cette solution offre tous les avantages attendus. En particulier le taux d'impuretés implantées dans un canal de conduction n'est pas décelable par l'examen au microscope. En outre le choix d'un même type de cellules, des cellules avec transistor à grille flottante, pour réaliser à la fois les cellules mémoires mortes et les cellules mémoire vives permet de définir, pour réaliser un prototype, un plan mémoire muni entièrement de cellules mémoires vives, avec des transistors à grille flottante, et de ne figer la répartition de ces cellules en cellules mémoires vives et cellules mémoires mortes qu'après la phase de mise au point du prototype. Pour un plan mémoire de capacité donnée il est alors tout à fait possible d'augmenter d'une manière sensible la taille des mémoires mortes. Dans tous les cas la taille du plan mémoire global peut rester identique.

En outre l'opération d'implantation des impuretés dans les canaux de conduction des transistors à grille flottante est une opération qui s'effectue assez tard dans le processus de fabrication. Donc de nombreuses opérations peuvent être réalisées pour fabriquer un circuit intégré électronique universel avant de le particulariser. De plus l'opération d'implantation n'est en elle-même pas spécifique. En effet, étant donné que pour le plan mémoire des cellules mémoires vives l'implantation est déjà nécessaire, mais que cette implantation n'est pas faite dans les circuits périphériques du plan mémoire, il est déjà nécessaire d'utiliser un masque. Toutes les opérations de photomasquage imposées par un procédé de fabrication de plans mémoire selon l'invention n'ont alors pour effet que de définir ce masque d'une manière différente, éventuellement plus précise, pour départager les différents types de cellules.

Par ailleurs dans une application où on exagère le taux d'impuretés implantées dans les cellules mémoire mortes programmées, un autre masque peut éventuellement se justifier. Cet autre masque est cependant réalisé et appliqué dans les mêmes conditions que le précédent.

L'invention à donc pour objet un plan mémoire muni d'une part de cellules mémoires vives programmables électriquement, ces cellules étant du type comportant un transistor à grille flottante, et muni d'autre part de cellules mémoires mortes, caractérisé en ce que les cellules mémoires mortes sont aussi du type comportant un transistor à grille flottante mais dont l'état de programmation est différencié par la performance de conduction du canal de conduction de ce transistor.

L'invention sera mieux comprise à la lecture de la description qui suit et à l'examen des figures qui l'accompagnent ; celles-ci ne sont données qu'à titre indicatif et nullement limitatif de l'invention. Les figures montrent :

— figures 1 à 3 : des courbes caractéristiques des performances de conduction des canaux de conduction des transistors à grille flottante mis en oeuvre dans l'invention ;

— figures 4 à 6 : des coupes schématiques de transistors de type MOS, programmés ou non, et munis ou non des implantations d'impuretés selon l'invention ;

— figure 7 : une représentation schématique d'un plan mémoire comportant des cellules mémoires mortes et des cellules mémoires vives ainsi qu'un dispositif de lecture du contenu d'informations de ces cellules mémoires.

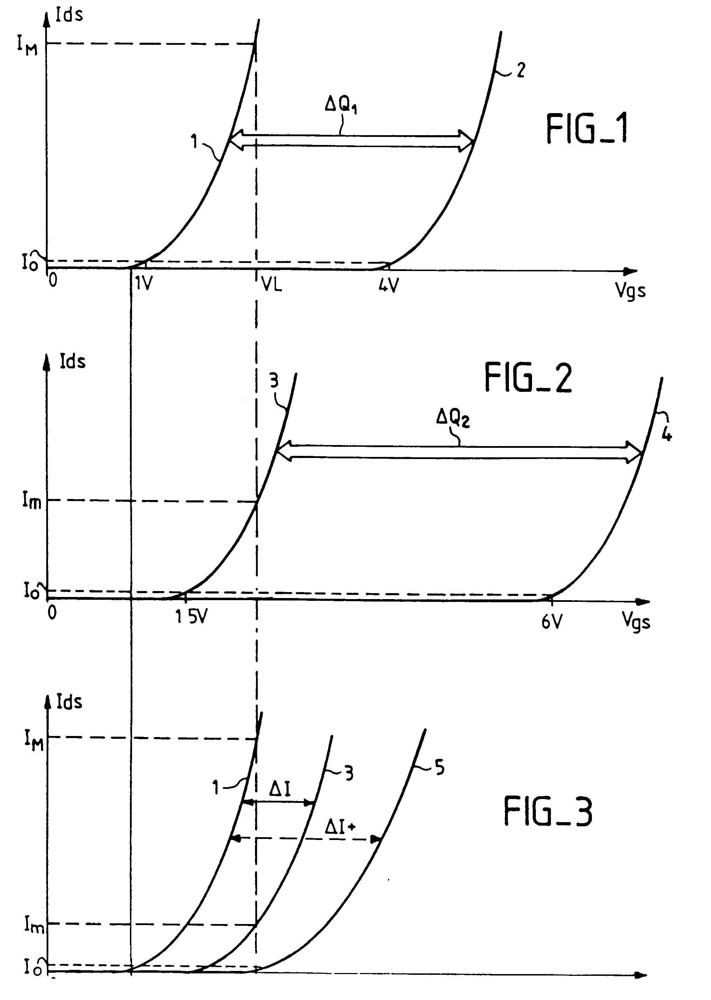

La figure 1 représente la courbe caractéristique Ids (Vgs) montrant l'allure du courant passant dans le canal de conduction d'un transistor à grille flottante en fonction de la tension grille-source appliquée à ce transistor, alors qu'il reçoit une tension positive entre drain et source, et selon qu'il se trouve dans un état de programmation ou dans un autre. La courbe 1 montre la réponse en courant d'un transistor à grille flottante vierge, c'est-à-dire non programmé. Ce transistor possède une tension de seuil de conduction de l'ordre de 1 volt et délivre un courant important IM lorsqu'on soumet son drain et sa source à une différence de potentiel égale à un potentiel de lecture VL, de l'ordre de 2,5 volts par exemple. Lorsque ce transistor est programmé, c'est-à-dire lorsque des électrons ont été injectés dans sa grille flottante en quantité $\wedge Q_1$, le seuil de conduction de ce transistor se décale et il ne devient plus conducteur, par exemple, que si on lui applique une tension entre grille et source de l'ordre de 4 volts. Comme cette tension est supérieure à la tension effectivement appliquée sur sa grille en lecture, ce transistor n'est pas susceptible de laisser passer un courant fort, il ne laisse passer qu'un courant très faible Io.

La figure 2 montre ce qu'il advient de la courbe caractéristique de la figure 1 lorsque les canaux de conduction des transistors à grille flottante ont été dopés, qu'ils soient dans un état de programmation ou dans un autre. Le seuil de conduction du transistor vierge est légèrement décalé, il est passé par exemple à 1,5 volts, et le courant que ce transistor est susceptible de laisser passer lorsqu'il est soumis à une même tension de lecture VL que précédemment est maintenant réduit, en conséquence il ne vaut plus que Im (courbe 3). Par contre quand le transistor a été programmé, l'injection de charges a été plus efficace : le nombre d'électrons $\Delta Q_2$ injectés dans sa grille flottante est maintenant supérieur au nombre de ceux qui avaient pu être injectés quand le canal de conduction n'avait pas été dopé. Il en résulte que le seuil de conduction du transistor à grille flottante dopé et programmé est maintenant décalé d'une manière beaucoup plus importante : par exemple il vaut 6 volts (courbe 4). Ceci a pour effet que le pouvoir de rétention de l'information dans ce transistor à grille flottante en est augmenté. Autrement dit le temps de fuite et le caractère non volatile du stockage de l'information dans un tel transistor à grille flottante est augmenté.

La figure 3, qui fait référence aux deux précédentes, montre l'exploitation de ce dopage en vue de constituer le mode de programmation des cellules mémoires mortes selon l'invention. Ce mode de programmation est effectué par masquage du plan mémoire au moment de la fabrication du circuit intégré électronique désiré. Il y est fait une distinction entre les cellules mémoires vierges dont le canal de conduction du transistor à grille flottante a une courbe caractéristique 1 identique à celle de la figure 1, et des cellules mémoires mortes dites programmées (sans qu'il soit injecté de charges dans la grille flottante) dont la courbe caractéristique de conduction du canal de conduction est la courbe 3 de la figure 2, ou même mieux, en exagérant le dopage, une courbe 5. Le décalage des courbes selon qu'elles sont programmées ou non ne correspond pas à une injection de charges électroniques $\Delta Q$ mais à une variation $\Delta I$ de l'implantation des impuretés dans ce canal de conduction.

La courbe 1 montre une cellule mémoire vierge susceptible de délivrer un courant IM au moment de la lecture avec une tension de lecture VL, alors que la courbe 3 montre que le transistor ne pourra que débiter un courant Im (du même type que celui de la figure 2). La mesure de la différence entre ces courants peut permettre de différencier l'état de programmation des cellules. Si l'implantation des impuretés est exagérée, la courbe 3 peut se déplacer jusqu'à l'endroit de la courbe 5 faisant décroître d'autant le courant Im, de manière à ce que celui-ci devienne proche de Io par exemple. Dans ce cas la mesure de l'état de programmation des cellules mémoires vives et des cellules mémoires mortes peut être effectuée avec un même senseur de courant dont le seuil de déclenchement se situe par exemple à 2.Io ou à Im/2.

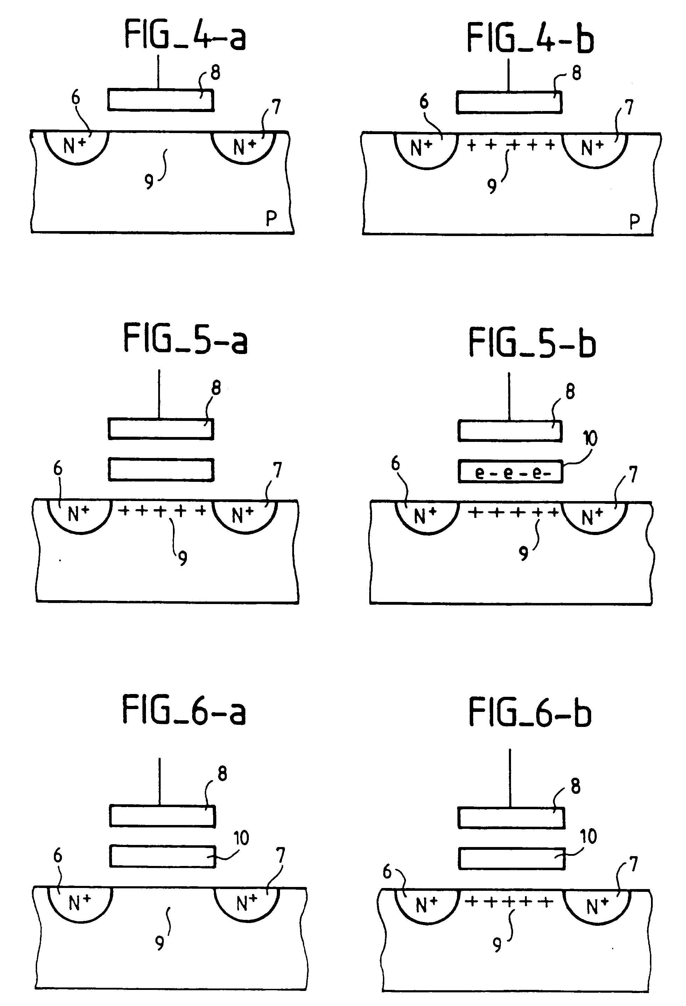

Les figures 4 à 6 montrent en coupe des représentations schématiques respectivement de transistors normaux, de transistors à grille flottante utilisables dans les cellules mémoires vives, et de transistors à grille flottante utilisables dans les cellules mémoires mortes. Les figures 4a et 4b montrent un transistor muni de régions drain et source respectivement 6 et 7 et d'une grille 8. Ce transistor est un transistor à canal N et il est conducteur quand un potentiel positif est appliqué sur sa grille 8. La différence entre la figure 4a et la figure 4b est matérialisée par la présence d'une implantation, dans cette dernière, d'impuretés de type P en surface du canal 9 de conduction de ce transistor. Ceci a pour effet de déplacer le seuil de conduction de ce transistor vers les valeurs élevées. En pratique avec une implantation d'atomes de Bore en concentration de $10^{17}$ atomes par $cm^3$, ce seuil de conduction vaut de l'ordre de deux volts.

Les figures 5a et 5b montrent des transistors à grille flottante dont le canal de conduction 9 a été dopé de manière à favoriser l'opération de programmation. La figure 5b montre schématiquement, par la présence d'électrons e$^-$ prisonniers dans la grille flottante 10 de ce transistor, sur quoi repose le principe de la program- mation. Par contre aux figures 6a et 6b on montre des transistors à grille flottante utilisables dans des cellules mémoires mortes et dont le caractère non programmé, figure 6a, et programmé, 6b, est matérialisé par la présence ou non d'une implantation d'impuretés dans le canal de conduction 9. Les comparaisons des figures 5 et 6 montrent que dans un plan mémoire mixte, comportant des cellules mémoires mortes et des cellules mémoires vives, la technologie de fabrication des transistors constituant les organes de mémorisation de ces cellules mémoires est la même : dans tout les cas il s'agit de transistors comportant des grilles flottantes.

Dans le cas où la comparaison des courant passant dans les transistors des cellules mémoires mortes amène à comparer un courant IM à un courant Im le plan mémoire ne comporte que deux types de transistors à grille flottante. Un premier type est constitué par les transistors dont le canal de conduction a été dopé par des implantations d'impuretés (figures 5a, 5b et 6b), l'autre type est constitué par des transistors à grilles flottantes dont le canal de conduction ne possède aucune impureté de dopage (figure 6a). On remarque dans ce cas une quasi impossibilité de définir par une observation extérieure si les cellules mémoires observées sont du type cellules mémoire mortes ou du type cellules mémoires vives quand il s'agit de cellules mémoires mortes programmées.

Dans le cas où on a exagéré l'implantation des impuretés dans le canal de conduction des cellules mémoires mortes programmées on peut de même se contenter de deux types de cellules mémoires : les cellules mémoires mortes non programmées comportant alors, elles aussi, le même type de concentration d'impuretés que les cellules mémoires vives vierges ; les cellules mémoires mortes programmées comportant dans le canal de conduction de leur transistor à grille flottante une plus grande concentration d'impuretés. On remarque d'ailleurs que dans ce dernier cas la distinction entre les cellules programmées et les cellules non programmées peut se faire de la même manière selon qu'elles sont vives ou mortes. Quand elles sont non programmées leur courant de conduction vaut Im, quand elles sont programmées leur courant de conduction vaut Io.

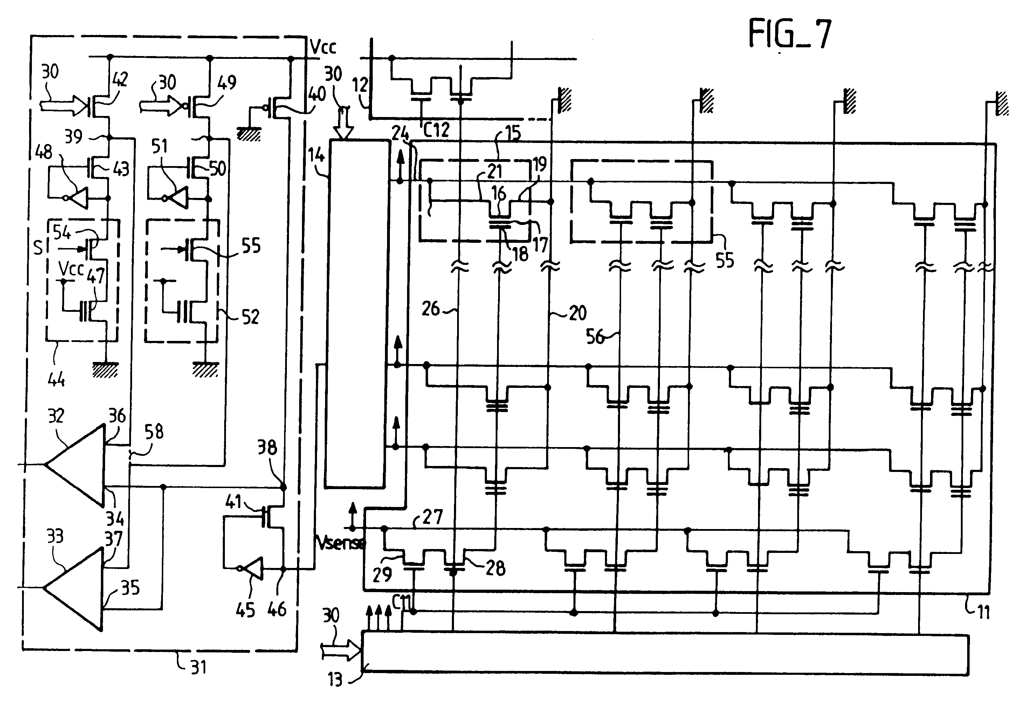

La figure 7 représente un plan mémoire muni de cellules mémoires selon l'invention. Ce plan mémoire comporte par exemple des blocs mémoires tels que 11 ou 12 comportant, chacun, un même nombre de cellules mémoires auxquelles on peut accéder par un décodeur de lignes de mots 13 et par un décodeur de lignes de bits 14. Chaque cellule mémoire, par exemple la cellule mémoire 15, comporte un transistor à grille flottante 16, muni d'une grille flottante 17 et d'une grille de commande 18, relié par sa source 19 à une connexion de masse de réseau 20, et par son drain 21 à une ligne de bits 24. Dans l'exemple représenté les cellules mémoires sont du type EPROM. Elles peuvent dans l'invention être du type EEPROM. Dans ce cas la cellule mémoire comporte, entre la ligne de bits 24 et le drain 21 un transistor de commande dont la grille est reliée à une ligne de mots, par exemple la ligne de mots 26. Les lignes de bits telles que 24 et les lignes de mots telles que 26 proviennent respectivement du décodeur de lignes de bits 14 et du décodeur de lignes de mots 13.

Pour chaque bloc mémoire une connexion de conditionnement 27 achemine un potentiel de sensibilisation V sense sur les grilles de commande 18 des transistors 16 à grille flottante des cellules mémoires.

Cet acheminement est organisé par la mise en série de deux transistors respectivement d'accès 28 et de contrôle d'accès 29 en série l'un avec l'autre entre la connexion 27 et les grilles de commande 18. Ces transistors reçoivent respectivement sur leur grille de commande le signal disponible sur la ligne de mots 26 et un signal C de commande de bloc. Par exemple le transistor 29 reçoit le signal C 11 relatif au bloc 11.

Lorsqu'une adresse 30 est appliquée sur les décodeurs 13 et 14, une cellule mémoire, par exemple la cellule mémoire 15, peut être lue. Un circuit de lecture 31 applique alors sur la ligne de bits 24 concernée par la cellule 15 un potentiel de lecture VL. Si la cellule mémoire 15 est programmée du courant passe avec une intensité sensible sur la ligne de bits 24, si elle n'est pas programmée le courant de fuite qui traverse la cellule 15 est faible. Le circuit de lecture 31 comporte des comparateurs pour extraire l'information d'état de programmation à partir de ce courant débité. Il comporte par exemple les deux comparateurs 32 et 33. Chacun de ces comparateurs 32 et 33 (qui dans la pratique sont des comparateurs de tension) reçoit sur une entrée respectivement 34 et 35 un signal correspondant au courant qui passe dans la cellule 15. Aux accès sur leurs autres entrées respectivement 36 et 37 les comparateurs 32 et 33 reçoivent un signal de référence relatif au fait que la cellule mémoire 15 est une cellule mémoire vive ou une cellule mémoire morte.

Les potentiels représentatifs du courant qui passe dans la cellule 15 et les potentiels de référence relatifs aux courants qui passent dans les cellules mémoires étalons 44 ou 52 sont élaborés de la même façon. Par exemple ces potentiels proviennent à chaque fois du point milieu respectivement 38 ou 39 d'un pont diviseur à transistors, comportant les transistors respectivement 40-41 et 42-43. Ces ponts diviseurs de transistors sont en série d'une part, par l'intermédiaire du décodeur 14 de lignes de bits, avec la cellule mémoire 15 à lire, et d'autre part avec la cellule mémoire étalon 44. Aux pertes de tension par commutation dans le décodeur 14 près, on remarque que la succession des transistors 40-41 et de la cellule mémoire 15 est du même type que la succession des transistors 42-43 et de la cellule mémoire étalon 44.

Le fonctionnement de chacune de ces cascades est le suivant. Par exemple le transistor 40 est un transistor à canal P dont la grille est reliée à la masse : il est toujours conducteur. Il se comporte en définitive comme une résistance. Le transistor 41 est un transistor à canal N, sa grille est commandée par un rebouclage de sa source au moyen d'un inverseur 45. Ce rebouclage agit comme un régulateur. On peut montrer que la tension de lecture VL disponible sur la source 46 du transistor 41 baisse un peu, mais faiblement, lorsque la cellule mémoire 15 choisie est programmée : lorsque son transistor 16 est passant.

Cette légère baisse de tension est néanmoins prise en compte par l'inverseur 45 pour être appliquée en contre-réaction sur la grille de commande du transistor 41. Ce dernier devient alors plus conducteur et injecte un courant plus important dans la cellule mémoire 15. La résistance interne de conduction de cette cellule mémoire fait alors remonter le potentiel disponible au point 46 de telle manière qu'on puisse considérer qu'il est sensiblement constant.

Dans ces conditions le potentiel disponible au point 38 résulte de la mise en série de la résistance de conduction du transistor 40 avec le transistor 41 entre deux potentiels sensiblement constants, Vcc d'une part et VL d'autre part. Compte tenu de la constance de la résistance de conduction du transistor 40 (il est toujours conducteur) on obtient au point 38 un potentiel représentatif du courant qui passe dans la cellule 15. Si la cellule 15 est programmée, si le transistor 16 est passant, le potentiel en 38 est faible. Dans le cas contraire le potentiel en 38 vaut sensiblement Vcc (moins la chute de tension dans le transistor 40).

Le potentiel de référence admis sur l'entrée 36 du comparateur de tension 32 est élaboré dans les mêmes conditions. La cellule étalon 44 peut être une cellule programmée : son transistor à grille flottante 47 est passant. Un inverseur 48 permet également d'obtenir une régulation de la tension de lecture appliquée à cette cellule étalon 44. En conséquence le potentiel disponible au point milieu 39 du pont diviseur à transistor 42-43 est obtenu dans les mêmes conditions. De manière à pouvoir faire une comparaison utile on choisit un transistor 42 deux fois moins résistant (deux fois plus gros) que le transistor 40. Pour un même courant débité dans les cellules à lire 15 et étalon 44, quand elles sont toutes deux programmées, le potentiel étalon disponible à l'entrée 36 du comparateur 32 est supérieur au potentiel du point 38 disponible à l'entrée 34 de ce comparateur 32. Par contre si la cellule 15 n'est pas programmée (ce qu'en définitive on cherche à savoir) le potentiel au point 38 est presque égal à Vcc. Il est donc supérieur au potentiel étalon disponible au point 39 qui lui ne change pas.

Dans le cas où la cellule 15 est une cellule mémoire vive on peut considérer que le signal disponible à l'entrée 34 du comparateur 32 est égal à Im ou à Io selon que cette cellule est programmée ou non, tandis que le signal disponible à l'entrée 36 du comparateur 32 doit être proportionnel à Im/2.

On a vu (figure 3) que si la cellule mémoire 15 est une cellule mémoire morte le courant qu'elle est susceptible de débiter peut être IM ou Im selon qu'elle n'est pas ou qu'elle est respectivement programmée. Il importe donc de comparer le courant débité par cette cellule 15 à IM/2. Cette nouvelle grandeur de référence est fournie par une autre cascade, du même type que les précédentes, comportant un autre pont diviseur de tension à transistors 49-50 en contre-réaction par un inverseur 51 et débitant dans une autre cellule étalon 52. Un autre comparateur 33 reçoit alors sur son entrée 35 un signal correspondant au courant qui passe dans la cellule mémoire à lire 15, et sur son entrée de référence 37 un signal délivré par le point milieu 53 du pont diviseur à transistors 49-50. Le choix de la tension de référence est tout à fait lié aux concentrations d'impuretés implantées dans les canaux de conduction des cellules mémoires mortes. La cellules mémoire étalon est bien entendu une cellule mémoire morte (programmée ou non selon le mode de comparaison choisi).

De manière à ne pas faire débiter inutilement les cellules mémoires étalons 44 et 52 il peut être prévu de mettre entre elles et leur pont diviseur à transistors respectif des transistors de commande respectivement 54 et 55 commandés par un signal commun S de validation de la lecture.

Il peut être utile de répartir les cellules mémoires mortes parmi les cellules mémoires vives de manière à compliquer la tâche du fraudeur et à le forcer à examiner toutes les cellules du plan mémoire, au cas où il trouverait un moyen d'observation extérieur pour révéler l'état d'implantation des impuretés dans les canaux de conduction des cellules mémoires. Il en résulte qu'une cellule mémoire 15 peut par exemple être une cellule mémoire morte tandis qu'une cellule voisine 55, sur la même ligne de bits, est une cellule mémoire vive. Ou bien pour simplifier, sur certaines lignes de bits, par exemple la ligne de bits 24, des cellules mémoires sont des cellules mémoires vives ou des cellules mémoires mortes selon qu'elles appartiennent à des lignes de mots de rang pair, ligne de mot 26, ou de rang impair ligne de mot 57. On peut alors utiliser le bit de parité de l'adresse-mot de la cellule mémoire à lire pour mettre en conduction, au choix, un des deux transistors 42 ou 49 et deux ponts diviseurs à transistors en cascade avec les cellules mémoires étalons respectivement 44 et 52. La cellules mémoire étalon dont le transistor est ainsi activé applique alors son potentiel de référence au comparateur correspondant. Ce comparateur peut délivrer l'information lue.

Pour cette raison l'adresse 30 (dans un cas simple le dernier bit de l'adresse-mot), est appliquée sur la grille de commande de ces transistors 42 et 49. De manière à les différencier, un de ces transistors sera un transistor à canal P tandis que l'autre sera un transistor à canal N. Par exemple pour une adresse impaire la cellule 15 programmable est lue. Le bit de parité vaut 1, et le transistor à canal N 42 est conducteur tandis que le transistor à canal P 49 est bloqué. Le cas inverse se produit pour la lecture de la cellule 56. Dans ces conditions les deux comparateurs 32 et 33 reçoivent sur leur entrée 34 et 35 respectivement, un même signal correspondant à l'information à lire, et un seul de ces comparateurs, selon la nature de la cellule mémoire à lire, délivre l'information lue. Ces deux comparateurs peuvent être remplacés par un comparateur unique. Par exemple le comparateur 32 peut recevoir sur son entrée 36 de référence, par une connexion 58, aussi bien le potentiel de référence élaboré par la cellule étalon 44 que celui élaboré par la cellule étalon 52. Seule celle de ces deux cellules qui est validée permet la comparaison. Le point milieu du pont diviseur à transistor de la cellule non validée reste en effet en l'air du fait du blocage de son transistor (42 ou 49).

La réalisation d'un prototype de circuit intégré avec un plan mémoire, contenant des mémoires mortes et des mémoires vives, est facilitée. Dans un premier temps on choisit un plan mémoire ne contenant que des mémoires vives. On peut y programmer, classiquement, dans une première phase les zones des cellules mémoires mortes (réparties en vue de gêner les fraudeurs). Puis dans une deuxième phase on peut y programmer, classiquement, toutes les applications auxquelles doit servir le circuit intégré électronique projeté. On teste alors fonctionnellement le circuit conçu. Lorsque la fonctionnalité recherchée est obtenue on détermine, dans les zones de mémoire morte, quelles cellules mémoires doivent être programmées ou non et quelle opération correspondante de photomasquage il en résulte. Par exemple dans le cas où les cellules non programmées ne comportent pas d'impuretés dans le canal de conduction de leur transistor à grille flottante on détermine un masque destiné à implanter des impuretés dans tous les canaux de conductions des cellules du plan mémoire (mortes ou vives) sauf dans celles que l'on vient justement d'exclure. La mise au point de la fabrication ne souffre d'aucun inconvénient supplémentaire puisque le photomasquage est déjà maîtrisé en tant qu'opération nécessaire à l'implantation d'impuretés dans les canaux de conduction des transistors des cellules mémoires vives elles-mêmes. On remarque que la caractéristique des circuits, à plan mémoire global constant peut être repoussée très loin dans le processus de fabrication.

## Revendications

1. Plan mémoire muni d'une part de cellules mémoires vives non volatiles programmables électriquement, ces cellules étant du type comportant un transistor (16) à grille (17) flottante, et muni d'autre part de cellules mémoires mortes, caractérisé en ce que les cellules mémoires mortes sont aussi du type comportant un transistor à grille flottante, mais dont l'état de programmation est différencié par la performance de conduction (figure 3) du canal de conduction de ce transistor.

2. Plan mémoire selon la revendication 1 caractérisé en ce que le canal de conduction des transistors à grille flottante des cellules mémoires mortes est dopé (figure 6) différemment avec des impuretés selon l'état de programmation à imposer.

3. Plan mémoire selon la revendication 2 caractérisé en ce que le canal de conduction est dopé (figure 6) ou non avec des impuretés selon l'état de programmation à imposer.

4. Plan mémoire selon l'une quelconque des revendications 1 à 3 caractérisé en ce que les performances de conduction du canal de conduction des transistors des cellules mémoires vives sont améliorées (figure 5) par une implantation d'impuretés dans ce canal.

5. Plan mémoire selon l'une quelconque des revendications 1 à 4 caractérisé en ce que les cellules mémoires mortes sont réparties (15, 56) parmi les cellules mémoires vives.

6. Plan mémoire selon l'une quelconque des revendications 1 à 5 muni de moyens (31) de lecture du contenu des cellules mémoires, les moyens de lecture comportant des moyens (32, 33) de comparaison du contenu d'information de ces cellules à une grandeur de référence, caractérisé en ce que les moyens de comparaison comportent des moyens (30, 42, 49) pour différencier les grandeurs de référence selon la nature des cellules mémoires à lire.

7. Plan mémoire selon l'une quelconque des revendications 1 à 5 muni de moyens (31) de lecture du contenu des cellules mémoires, les moyens de lecture comportant des moyens de comparaison du contenu de ces cellules à une grandeur de référence, caractérisé en ce qu'il comporte des moyens (1, 5) pour qu'une même grandeur de référence soit utilisée quelque soit la nature des cellules.

8. Prototype de définition d'un circuit intégré électronique, ce circuit intégré électronique étant prévu pour comporter un plan mémoire muni de cellules mémoires vives et de cellules mémoires mortes selon l'une quelconque des revendications 1 à 7, caractérisé en ce que le plan mémoire du prototype ne contient que des cellules mémoires vives.

9. Procédé de définition d'un circuit intégré électronique comportant un plan mémoire muni de cellules mémoires vives et de cellules mémoires mortes selon l'une quelconques des revendications 1 à 7, caractérisé en ce qu'il comporte les étapes suivantes:
— on réalise un prototype ne contenant que des cellules mémoires vives,
— on détermine à quels endroits des cellules mémoires vives sont destinées à devenir, dans le circuit à définir, des cellules mémoires mortes,
— et on réalise les cellules mémoires mortes aux endroits déterminés.

## Patentansprüche

1. Speicherebene, die einerseits mit Zellen von elektrisch programmierbaren, nichtflüchtigen Schreib-/Lesespeichern versehen ist, wobei diese Zellen von einem Typ sind, der einen Transistor (16) mit schwebendem Gate (17) aufweist, und andererseits mit Zellen von Festwertspeichern versehen ist, dadurch gekennzeichnet, daß die Festwertspeicher-Zellen ebenfalls von dem Typ sind, der einen Transistor mit schwebendem Gate aufweist, dessen Programmierungszustand sich jedoch durch die Leitungseigenschaft (Fig. 3) des Leitungskanals dieses Transistors unterscheidet.

2. Speicherebene gemäß Anspruch 1, dadurch gekennzeichnet, daß der Leitungskanal der Transistoren mit schwebendem Gate der Festwertspeicher-Zellen entsprechend dem zuzuteilenden Programmierungszustand mit Störstellen verschieden dotiert ist (Fig. 6).

3. Speicherebene gemäß Anspruch 2, dadurch gekennzeichnet, daß der Leitungskanal entsprechend dem zuzuteilenden Programmierungszustand mit Störstellen dotiert ist oder nicht (Fig. 6).

4. Speicherebene gemäß einem der Ansprüche 1 bis 3, dadurch gekennzeichnet, daß die Leitungseigenschaften des Leitungskanals der Transistoren der Schreib-/Lesespeicher- Zellen durch die Implantation von Störstellen in diesen Kanal verbessert sind (Fig. 5).

5. Speicherebene gemäß einem der Ansprüche 1 bis 4, dadurch gekennzeichnet, daß die Festwertspeicher-Zellen unter den Schreib-/Lesespeicher-Zellen verteilt (15, 56) sind.

6. Speicherebene gemäß einem der Ansprüche 1 bis 5, die mit Mitteln (31) zum Lesen des Inhaltes der Speicherzellen versehen ist, wobei die Mittel zum Lesen Mittel (32, 33) zum Vergleichen des Informationsgehaltes dieser Zellen mit einer Bezugsgröße aufweisen, dadurch gekennzeichnet, daß die Mittel zum Vergleichen Mittel (30, 42, 49) zum Unterscheiden der Bezugsgrößen entsprechend der Art der zu lesenden Speicherzelle aufweisen.

7. Speicherebene gemäß einem der Ansprüche 1 bis 5, die mit Mitteln (31) zum Lesen des Inhaltes der Speicherzellen versehen ist, wobei die Mittel zum Lesen Mittel zum Vergleichen des Inhaltes dieser Zellen mit einer Bezugsgröße aufweisen, dadurch gekennzeichnet, daß sie Mittel (1, 5) aufweist, damit unabhängig von der Art der Zellen dieselbe Bezugsgröße verwendet wird.

8. Prototyp zur Definition einer elektronischen integrierten Schaltung, die dazu vorgesehen ist, eine mit Schreib-/Lesespeicher-Zellen und Festwertspeicher-Zellen versehene Speicheranordnung gemäß einem der Ansprüche 1 bis 7 aufzunehmen, dadurch gekennzeichnet, daß die Speicheranordnung des Prototyps nur die Schreib-/Lesespeicher-Zellen enthält.

9. Verfahren zur Definition einer elektronischen integrierten Schaltung, die eine mit Schreib-/Lesespeicher-Zellen und Festwertspeicher-Zellen versehene Speicheranordnung gemäß einem der Ansprüche 1 bis 7 aufweist, dadurch gekennzeichnet, daß es die folgenden Schritte enthält :

— Verwirklichung eines Prototyps, der nur die Schreib-/Lesespeicher-Zellen enthält,
— Bestimmen derjenigen Positionen der Schreib-/LesespeicherZellen, an denen in der zu definierenden Schaltung die Festwertspeicher-Zellen entstehen sollen,
— und Verwirklichung der Festwertspeicher-Zellen an den bestimmten Positionen.

## Claims

1. A memory plane provided on the one hand with memory read-write, non-volatile, electrically programmable cells, said cells being of the type comprising a floating gate (17) transistor (16), and provided on the other hand with read-only memory cells, characterized in that the read-only memory cells are also of the type comprising a floating gate transistor but whose programmed condition is changed by the conduction performance (figure 3) of the conduction channel of the said transistor.

2. The memory plane as claimed in claim 1, characterized in that the conduction channel of the floating gate transistors of the read-only memory cells is doped (figure 6) differently with impurities in accordance with the programmed condition to be provided.

3. The memory plane as claimed in claim 2, characterized in that the conduction channel is doped (figure 6) or is not doped with impurities in accordance with the programming condition to be provided.

4. The memory plane as claimed in any one of the preceding claims 1 through 3, characterized in that the conduction performances of the conduction channel of the transistors of the write-read memory cells are improved (figure 5) by the implantation of impurities in this channel.

5. The memory plane as claimed in any one of the preceding claims 1 through 4, characterized in that the read-only memory cells are distributed (15 and 56) among the write-read memory cells.

6. The memory plane as claimed in any one of the preceding claims 1 through 5 provided with means (31) for reading the content of the memory cells, the means for reading comprising means (32 and 33) for comparison of the information content of these cells with a reference magnitude, characterized in that the means for comparison comprises means (30, 42 and 49) in order to distinguish the reference magnitudes in accordance with the nature of the cells to be read.

7. The memory plane as claimed in any one of the preceding claims 1 through 5, provided with read means (31) for reading the content of the memory cells, the read means comprising means for the comparison of the contents of said cells with a reference magnitude, characterized in that it comprises means (1 and 5) ensuring that a single reference magnitude may be utilized whatever the nature of the cells.

8. A definition prototype for an electronic integrated circuit, said electronic integrated circuit being provided for having a memory plane provided with write-read memory cells and read-only memory cells as claimed in any one of the preceding claims 1 through 7, characterized in that the prototype memory plane only comprises write-read memory cells.

9. A method of defining an electronic integrated circuit comprising a memory plane provided with write-read memory cells and with read-only memory cells as claimed in any one of the preceding claims 1 through 7, characterized in that it comprises the following stages :

— the production of a prototype only containing write-read memory cells,

— determination at which positions write-read memory cells are destined to become read-only cells in the circuit to be defined, and

— production of the read-only memory cells at the given positions.

FIG_1

FIG_2

FIG_3

FIG_4-a  FIG_4-b

FIG_5-a  FIG_5-b

FIG_6-a  FIG_6-b

FIG_7

EP 0 317 442 B1